# EUROPÄISCHE PATENTSCHRIFT

(11) **EP 0 722 581 B1**
(45) Veröffentlichungstag und Bekanntmachung des Hinweises auf die Patenterteilung: **05.12.2001**
(21) Anmeldenummer: 94926050.9
(22) Anmeldetag: 07.09.1994
(51) Int. Cl.: G06F 3/12

(54) **VERFAHREN ZUR ELEKTRONISCHEN MONTAGE VON DRUCKBÖGEN**
METHOD FOR THE ELECTRONIC ASSEMBLY OF PRINTER'S FORMS
PROCEDE DE MONTAGE ELECTRONIQUE DE CAHIERS DE FEUILLES D'IMPRESSION

(30) Priorität: 07.09.1993 DE 4330242
(43) Veröffentlichungstag der Anmeldung: 24.07.1996
(73) Patentinhaber: Heidelberger Druckmaschinen Aktiengesellschaft, 69115 Heidelberg (DE)
(72) Erfinder: KASTENHOLZ, Peter, D-35510 Butzbach (DE); GAHLER, Arno, D-61389 Schmitten (DE)
(86) Internationale Anmeldenummer: DE9401024
(87) Internationale Veröffentlichungsnummer: WO9507507

(56) Entgegenhaltungen:
- CT MAGAZIN FUER COMPUTERTECHNIK, Nr.6, Juni 1991, HANNOVER Seiten 84 - 90 C. HERRMANN 'IM RAHMEN DES UNUEBLICHEN'
- ELEKTRONIK., Bd.40, Nr.11, 28. Mai 1991, MUNCHEN DE Seiten 64 - 70 J. HERTWIG 'DRUCKEN WIE DIE PROFIS'

## Beschreibung

Die Montage der einzelnen Seiten zu Druckbögen kann manuell oder mittels einer Montagestation durchgeführt werden. Eine Montagestation ist ein "WYSIWIG-Bildschirmarbeitsplatz" (WYSIWIG = what you see is what you get), an welchem unter Sichtkontrolle mehrere Seiten, die als sog. PostScript-Seiten vorliegen, zu einem Bogen zusammengefaßt werden. Aufbau und allgemeine Funktionsweise einer solchen Druckbogen-Montagestation sind in dem Prospekt "Signastation" der Firma Linotype-Hell, Deutschland, Seiten 1 bis 8, Bestell-Nr. 1292T MDO Lino 001/4d, 188-198 FHM, beschrieben. Der montierte Bogen wird als PostScript-Dokument gedruckt und beinhaltet sämtliche Informationen, die für eine sog. durckkonforme Ausgabe nötig sind. PostScript ist eine Seitenbeschreibungssprache, die von der Fa. Adobe Systems, Mountainview, Ca., U.S.A. entwickelt, im Markt eingeführt und zum Weltstandard geworden ist. Diese Seitenbeschreibungssprache ist beispielsweise in dem Manual "PostScript Language Reference Manual, Second Edition, Addison-Wesley Publishing Company, Inc., ISBN 0-201-18127-4", beschrieben. Es handelt sich um eine Programmsprache, die auf sog. RIP's (RIP = Raster Image Processor) abläuft, an die ein Filmbelichter, auch Recorder oder Imagesetter genannt, zum Ausgeben der Seiten auf Film angeschlossen ist. Bei diesen Programmen, auch DTP-Programme (DTP = Desktop Publishing) genannt, wird ein sog. PostScript-Job erstellt, in dem mehrere Seiten hintereinander in einer Datei (File) stehen. Diese Jobs werden auch "Print-to-Disk-Dateien" genannt und können mehrere Megabytes groß sein.

Sehr häufig wird die Montagestation in Verbindung mit einem Server innerhalb eines Bild- und Textverarbeitungssystems betrieben. Der Server hat mehrere Funktionen, u.a. dient er sowohl als Ablagesystem für die zu verarbeitenden PostScript-Dokumente (File-Server) als auch als Empfangs- und Ausgabesystem für zu belichtende Bogen (Print-Server). Die Verbindung zwischen der Montagestation und dem Server und den übrigen Komponenten des Bild- und Textverarbeitungssystem erfolgt über ein Netzwerk, z.B. Ethernet. Bei dieser Kommunikation zwischen der Montagestation und dem RIP über den Server werden die einzelnen auszuschießenden Seiten auf dem Server asynchron während des interaktiven Ausschieß-Prozessor zu ganzen PostScript-Druckbögen zusammengestellt. Dabei werden die Daten mehrmals über das Netz übertragen. Dies erfordert enorme Netzwerkressourcen, da Datenvolumina von über 100 Megabytes übertragen werden müssen. Dies beeinflußt außerdem das Zeitverhalten des Systems nachhaltig negativ und die Montagestation ist während dieser Zeit für andere Aufgaben blockiert.

Aufgabe des erfindungsgemäßen Verfahren ist es bei einer Druckbogen-Montagestation in Verbindung mit einem Server und/oder RIP durch Senkung der Netzwerkbelastung die Geschwindigkeit zu erhöhen und das gesamte Leistungsverhalten des Systems zu verbessern. Außerdem soll die bisherige zeitintensive, kostenaufwendige und zum Teil fehlerbehaftete Montage in einem schnellen und sicheren elektronischen Prozeß durchgeführt werden.

Diese Aufgabe wird durch die im kennzeichnenden Teil des Anspruchs angegebenen Merkmale gelöst.

Die Erfindung wird im folgenden anhand der Figuren 1 bis 3 näher erläutert. Es zeigen:
- Fig. 1: das Seitenmontageverfahren entsprechend dem Stand der Technik,
- Fig. 2: einen schematischen Ablauf des erfindungsgemäßen Seitenmontage verfahren u n d
- Fig. 3: eine Darstellung des Datenflusses gemäß der Erfindung.

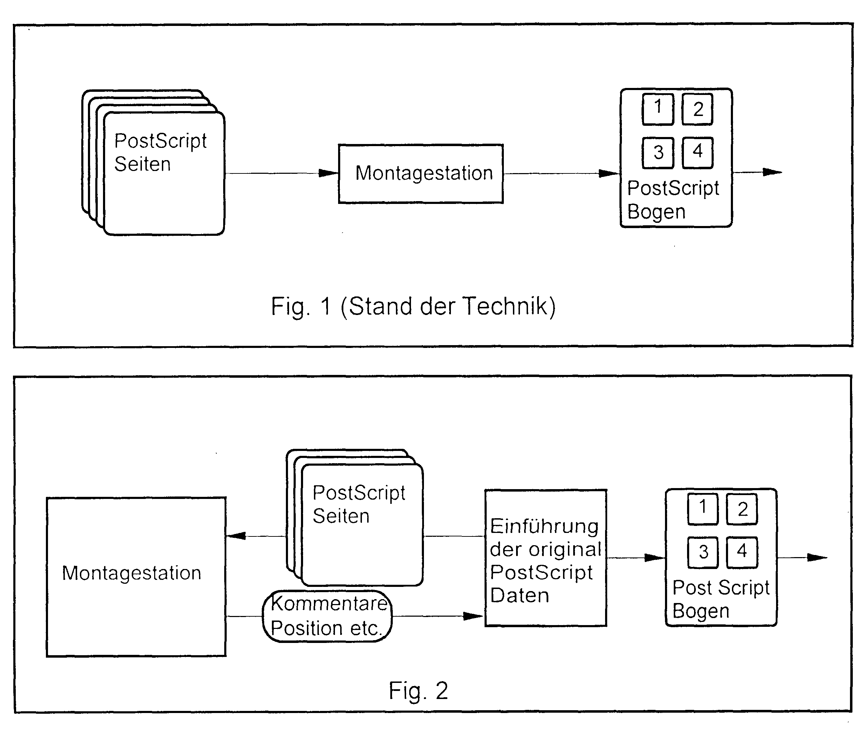

In Fig. 1 wird der Ablauf gemäß dem Stand der Technik beschrieben. Die Daten der kompletten PostScript-Seiten, d.h. der Print-to-Disk-Jobs liegen, wie bereits eingangs beschrieben, als Dateien auf dem Server. Der Datenfluß bei der Montage eines Druckbogens, d.h. der Generierung eines Bogen-PostScript-Jobs ist wie folgt. Diese Seiten, d.h. das PostScript-Dokument, bzw. der Print-to-Disk-Job wird als entsprechende Datei in Pfeilrichtung vom Server über das Netz in die Montagestation geladen. Die Montagestation merkt sich intern, welche Seiten existieren und an welchen Positionen sie innerhalb der Print-to-Disk-Datei liegen. Den Inhalt der Seiten merkt sich die Montagestation nicht, da es sich um Dateien handelt, die mehrere hundert Megabytes groß sein können. Um in der Montagestation einen Bogen-PostScript-Job zu generieren, muß die Montagestation also den ursprünglichen Print-to-Disk-Job, d.h. die entsprechende Datei ein zweites Mal vom Server auf die Montagestation holen, um den Teil mit den aktuell einzubauenden Seiten daraus herausschneiden und in den eigenen Bogen-PostScript-Job einzutragen. Nach der Montage wird dieser Bogen-PostScript-Job wieder als Datei über das Netz an den Print-Server-Funktionsbereich des Servers (Drucker-Queue) zurückgeschickt. Der in Fig. 1 auf der linken Seite gezeigte Speicher, in dem die PostScript-Seiten abgespeichert sind und der rechte Speicher, in dem der PostScript-Bogen, der die Seiten 1, 2, 3 und 4 enthält, sind Speicherbereiche des Severs. Insgesarnt werden also die Seiteninhalte dreimal über das Netz übertragen, da die Verbindung zwischen Montagestation und Server über das Netz erfolgt.

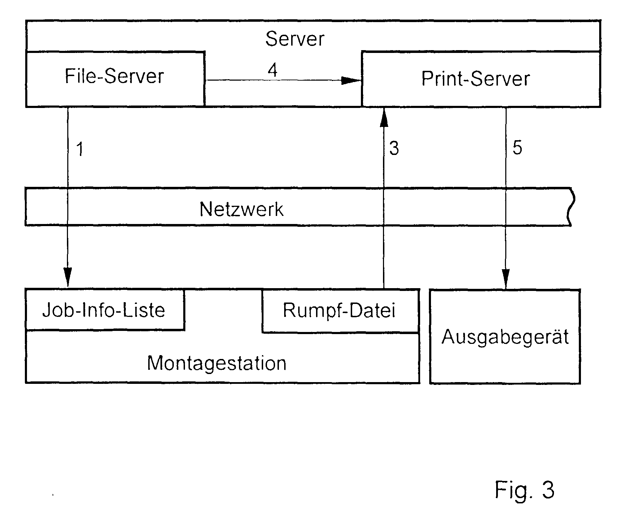

Das erfindungsgemäße Verfahren wird im folgenden grundsätzlich erläutert und dann anhand der Fig. 2 und 3 näher beschrieben.

Die PostScript-Seiten werden vom Speicher des Servers in die Montagestation übertragen. Gemäß der Erfindung wird in der Montagestation in den Bogen-PostScript-Job , d.h. in die Bogen-PostScript-Datei, der Inhalt der einzelnen Seiten nicht mehr aufgenommen, sondern nur noch jeweils ein Verweis, wo der einzelne Seiteninhalt in der Print-to-Disk-Datei zu finden ist. Die so erstellte neue Bogen-PostScript-Datei (Rumpf-Datei) wird dann über das Netz an den Server übertragen. Dies ist in Fig. 2 mit "Kommentare, Positionen etc." gekennzeichnet, die von der Montagestation in den Server übertragen werden. Diese Datei ist wesentlich kleiner als die letztlich auf dem Server für die Belichtung erzeugte Datei. Sie verfügt also nur noch über einen Bruchteil der Daten einer solchen nach dem Stand der Technik erzeugten Bogen-PostScript-Datei. Der Schreibzugriff des Netzes auf diese "Rumpfdatei" kann daher im Hinblick auf einen Schreibzugriff auf eine entsprechende Bogen-PostScript-Datei, die gemäß Stand der Technik erstellt worden wäre, vernachlässigt werden.

Diese in dieser Datei enthaltenen Verweise werden auch Ausschießbefehle (Include-Befehle) genannt. Die Ausschießbefehle werden nach der Übertragung der Datei auf den Server in einem separaten auf dem Server ablaufenden Prozeß, ohne daß das Netz belastet wird, ausgeführt. Dies erfolgt im Blockschaltbild der Fig. 2 innerhalb des Blocks "Einfügung der original PostScript-Daten". Die Befehle bewirken, daß die richtigen Seiteninhalte, d.h. die richtigen Teile der die einzelnen Seiten beschreibenden Print-to-Disk-Dateien (PostScript-Files) an der entsprechenden Stelle der Bogen-PostScript-Datei, die von der Montagestation erzeugt worden ist, eingefügt werden. Hierbei wird die entsprechende Seite auf die gewünschte Stelle innerhalb des Druckbogens positioniert, d.h. montiert. Dieser Prozeß findet in dem Teil des Servers statt, der eingangs mit Print-Server bezeichnet worden ist. Es werden einfach die Seiteninhalte aufgerufen und in die Bogen-PostScript-Datei, die von der Montagestation in den Server übertragen worden ist, einkopiert. Dies ist besonders einfach, da beide Dateien im Server liegen und ein direkter Zugriff auf die benötigten Daten ohne Netz möglich ist.

Fig. 3 zeigt in 5 Schritten, wie dies im einzelnen abläuft. Die PostScript-Dokumente werden im Schritt (1) vom Server, d.h. vom File-Server in die Montagestation, die auch "Workstation" genannt wird, übertragen. Wie bereits erwähnt, sind die zu verarbeitenden PostScript-Dokumente meist mehrseitig, auch immer dann, wenn mit Farbe gearbeitet wird, d.h. wenn farbige Bilder verarbeitet werden, da mehrere Farbauszüge für die Wiedergabe eines Farbbildes erforderlich sind. Um den im Vorangehenden beschriebenen Prozeß ausführen zu können, werden, da man für das Ausschießendie Einzelseiten benötigt, innerhalb der Montagestation in einem einfachen Sortiervorgang die eingehenden PostScript-Dokumenten so analysiert, daß der Ort jeder Seite innerhalb der Originaldatei festgestellt und gespeichert wird. Mit dieser Information kann dann jede Seite gezielt aufgerufen, bzw. adressiert werden. Die Abspeicherung dieser Daten erfolgt in einer Liste, die auch "Job-Info-Liste" genannt wird. Diese Liste enthält also die Verweise oder Adressen, unter denen die einzelnen Seiten innerhalb des Originaldokumentes aufgefunden werden können. Im folgenden ist eine solche Job-Info Liste für ein einfaches PostScript-Dokument dargestellt.

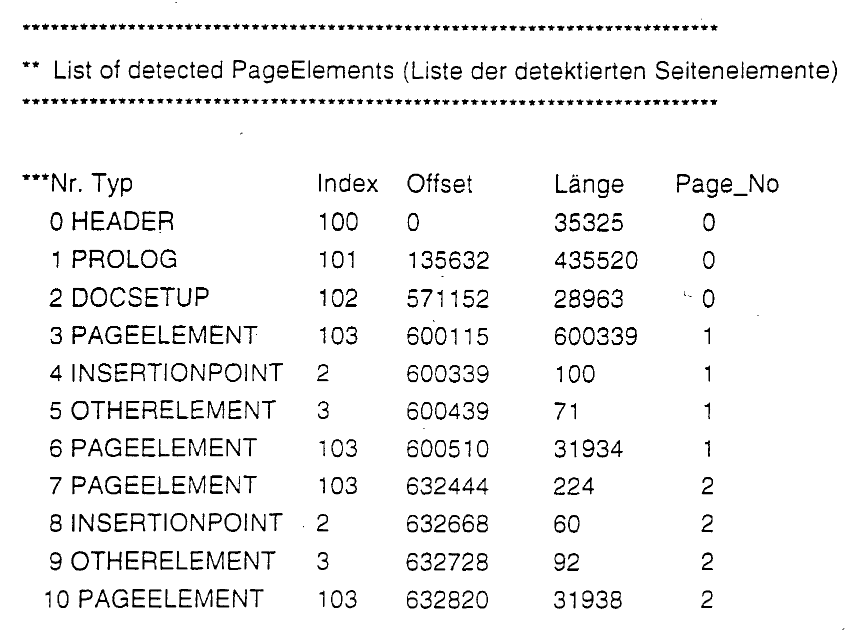

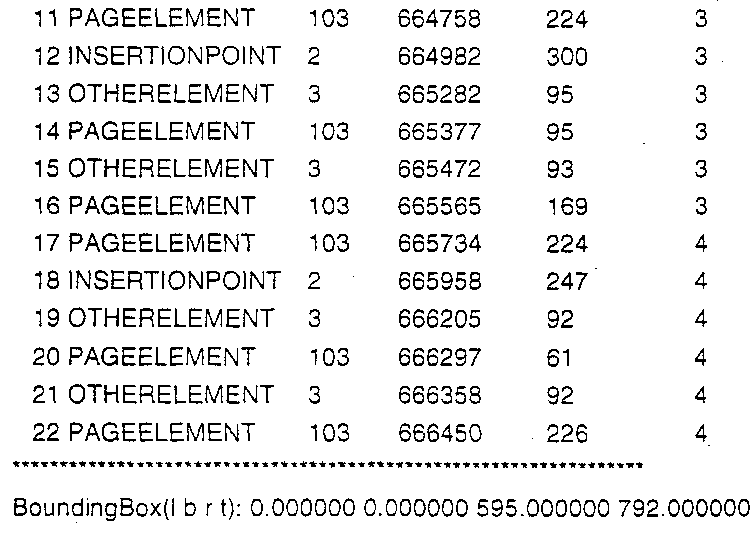

Nun ist es möglich, anhand dieser Job-Info Liste gezielt bestimmte Seiten im PostScript-Dokument zu adressieren und in den Ausgangsjob einzufügen. Im Schritt (2) wird mit Hilfe dieser Job-Info-Liste wird innerhalb der Montagestation eine Rumpf-Datei erstellt, die im Schritt (3) in den Bereich "Print-Server" des Servers übertragen wird. Wie bereits erwähnt sind in diese Rumpf-Datei nur diese Verweise über den Ort der Seiten innerhalb der ursprünglichen Post-Script-Datei aufgenommen worden, so daß es im Print-Server möglich ist anhand dieser Rumpf-Datei den ganzen PostScript-Bogen aufzubauen.

Die folgende Liste zeigt ein Beispiel für eine solche Rumpf-Datei. Alle Zeilen, die mit der Zeichenfolge "%%LMInclude:" beginnen, enthalten einen Dateinamen, einen Offset und eine Länge mit deren Hilfe gemäß der Erfindung der vollständige Druckjob erzeugt werden kann.
%!PS-Adobe-2.0
%%Title: x
%%Creator: LinoMontage
%%CreationDate: Mon Aug 22 14:51:30 1994
%%For: pierre
%%Pages: 1 1
%%BoundingBox: 0.000000 0.000000 842.000000 595.000000
%%PrintMode: PROOF
%%Orientation: Landscape
%%EndComments

userdict/LinoMontageSaveDict 3 dict def
LinoMontageSaveDict begin
/LM_sigsave{//LinoMontageSaveDict /LM_SIGSAVE save put }def
/LM_sigrestore{ clear//LinoMontageSaveDict /LM_SIGSAVE get restore }def end

//LinoMontageSaveDict /LM_sigsave get exec
%%BeginProlog
..
..
%%EndProlog
%%BeginDocumentSetup
//LinoMontageDict /LM_Reset get exec
%+ Document Supplied Fonts
%%LM_EndDocumentSetup
%%_LM_Page: 1 1
%%Information für potentielle Farbmarke
   //LinoMontageDict /LM_ColorCount 1 put
   %%BeginApplication: 1
%%ApplicationDocument:
   /Net/nxserv/PostScriptPool/Code/QuarkMac/Quark3.3_Mac/XP3.3_LW8.ps
//LinoMontageDict /LM_SaveApplication get exec
//LinoMontageDict /LM_Reset get exec
%%BeginApplicationProlog:
%+ Reencode Fonts
%%EndApplicationProlog:
%%BeginElement: 1
(1)
   //LinoMontageDict /LM_SaveElement get exec
%%BeginElementSetup
//LinoMontageDict /LM_Reset get exec
//LinoMontageDict /LM_RestoreState get exec
44.994377 44.994377 639.994385 836.994385
   44.994377 44.994377 639.994385 836.994385
   0.000000 1.000000 1.000000
   //LinoMontageDict /LM_SetElementSystem get exec
   %%EndElementSetup
   %+ Application DocumentSetup
%%LMlnclude:
/Net/nxserv/PostScriptPool/Code/QuarkMac/Quark3.3_Mac/XP3.3_LW8.ps 571152 28963
%+ Application Page
%%LMInclude:
   /Net/nxserv/PostscriptPool/Code/QuarkMac/Quark3.3_Mac/XP3.3_LW8.ps 600115 224
%%LMInclude:
   /Net/nxserv/PostScriptPool/Code/QuarkMac/Quark3.3_Mac/XP3.3_LW8.ps 600439 71
%%LMInclude:
   /Net/nxserv/PostScriptPool/Code/QuarkMac/Ouark3.3_Mac/XP3.3_LW8.ps 632728 92
%%LMInclude:
   /Net/nxserv/PostScriptPool/Code/QuarkMac/Quark3.3_Mac/XP3.3_LW8.ps 665282 95
%%LMInclude:
   /Net/nxserv/PostScriptPool/Code/QuarkMac/Quark3.3_Mac/XP3.3_LW8.ps 665472 93
%%LMInclude:
   /Net/nxserv/PostScriptPool/Code/QuarkMac/Quark3.3_Mac/XP3.3_LW8.ps 666205 92
%%LMInclude:
   /Net/nxserv/PostScriptPool/Code/QuarkMac/Quark3.3_Mac/XP3.3_LW8.ps 666358 92
%%LMInclude:
   /Net/nxserv/PostScriptPool/Code/QuarkMac/Quark3.3_Mac/XP3.3_LW8.ps 600339 100
%%LMDeleted
%%LMInclude:
   /Net/nxserv/PostScriptPool/Code/QuarkMac/Quark3.3_Mac/XP3.3_LW8.ps 600510 31934
%+ Application Trailer
//LinoMontageDict /LM_ClearState get exec
//LinoMontageDict /LM_RestoreElement get exec
%%EndElement: 1
//LinoMontageDict /LM_RestoreApplication get exec
%%Application Document:
   /Net/nxserv/PostScriptPool/Code/QuarkMac/Quark3.3_Mac/XP3.3_LW8.ps
%%EndApplication: 1
%+ Marks for Element: 1
%%Trailer
//LinoMontageDict /LM_old_showpage get exec
%%Ende Ausgabe der Signatur
//LinoMontageDict /LM_EndSignature get exec
//LinoMontageSaveDict /LM_sigrestore get exec
   %%Title: x
   %%Creator: SignaStation
   %%CreationDate: Mon Aug 22 14:51:30 1994
   %%For: pierre
   %%BeginTrailerLOC
   %%EndTrailerLOC

Das erfindungsgemäße Verfahren wird auch mit "Remote Page Including", (RPI), bezeichnet, wobei "Remote Page Including" bedeutet, daß die Post-Script-Daten nicht in der Montagestation, sondern erst auf dem Server in das an den Belichter auszugebende Dokument eingefügt (includiert) werden.

Ein großer Vorteil dieses Verfahrens ist es, daß die Daten nur einmal über das Netz kopiert werden, wodurch Netzwerk- und Zeitverhalten positiv beeinflußt werden und Netzkapazität für andere Prozesse frei wird.

## Patentansprüche

1. Verfahren zur elektronischen Montage von Druckbogen mittels eines als Montagestation ausgebildeten Bildschirmarbeitsplatzes, der über ein Netzwerk mit einem Server verbunden ist, wobei
mittels der Montagestation das Ausschießen der Seiten zu einem Druckbogen vorgenommen wird und eine Bogen-PostScript-Datei erstellt wird, die sämtliche Daten zur Ausgabe des Druckbogens mittels einer Ausgabestation enthält,
einzelne PostScript-Seiten als PostScript-Job hintereinander in einer oder mehreren Print-to-Disk-Dateien auf dem Server gespeichert sind,
die Print-to-Disk-Datei oder Dateien über das Netz in die Montagestation geladen werden, wobei in der Montagestation gespeichert wird, welche Seiten vorhanden sind und welche Positionen die einzelnen Seiten innerhalb der entsprechenden Print-to-Disk-Datei haben, **dadurch gekennzeichnet, daß**
auf der Montagestation eine erste Bogen-Postscript-Datei erstellt wird, die anstelle der Inhalte der einzelnen Seiten der Print-to-Disk-Datei oder Print-to-Disk-Dateien Ausschießbefehle enthält, die angeben, wo die einzelnen Seiten auf dem Druckbogen angeordnet werden und wo sich die einzelnen Seiten innerhalb der Print-to-Disk-Datei oder Dateien befinden,
die so erstellte erste Bogen-PostScript-Datei über das Netz an den Server übertragen wird,
im Server mittels der Ausschießbefehle eine zweite Bogen-PostScript-Datei erstellt wird, indem mittels der Ausschießbefehle die Inhalte der Seiten des Bogens aus der oder den sich auf dem Server befindlichen Print-to-Disk-Dateien aufgerufen und in die von der Montagestation auf den Server übertragene erste Bogen-PostScript-Datei an der Stelle eingefügt werden, an der sie auf dem Druckbogen angeordnet werden u n d
die zweite Bogen-PostScript-Datei vom Server an die Ausgabestation übertragen wird.

## Claims

1. A method for the electronic composition of printed sheets by means of a screen work station constructed as a composition station, which is connected with a server via a network, in which
by means of the composition station, the imposition of the pages into a printed sheet is undertaken and a sheet PostScript file is set up, which contains all the data for the issue of the printed sheet by means of an issuing station,
individual PostScript pages are stored as a PostScript job in succession in one or more print-to-disk files on the server,
the print-to-disk file or files are loaded via the network into the composition station, in which there is stored in the composition station which pages are present and which positions the individual pages have within the corresponding print-to-disk file, **characterised in that**
on the composition station, a first sheet PostScript file is set up, which instead of the contents of the individual pages of the print-to-disk file or print-to-disk files contains imposition commands, which indicate where the individual pages are arranged on the printed sheet and where the individual pages are to be found within the print-to-disk file or files,
the first sheet PostScript file which is thus set up is transferred to the server via the network,
in the server, by means of the imposition commands, a second sheet PostScript file is set up, in which by means of the imposition commands the contents of the pages of the sheet are called up from the print-to-disk file or files situated on the server and are included in the first sheet PostScript file,
transferred from the composition station to the server at the position at which they are arranged on the printed sheet, and
the second sheet PostScript file is transferred from the server to the issuing station.

## Revendications

1. Procédé de montage électronique de cahiers d'impression à l'aide d'un poste de travail à écran en forme de station de montage, relié à un serveur par l'intermédiaire d'un réseau,
dans lequel
- à l'aide du poste de montage on effectue l'éjection des pages sous la forme d'un cahier d'impression et on établit un fichier de cahiers PostScript contenant toutes les données pour l'émission du cahier d'impression, à l'aide d'un poste d'émission,
- certaines pages PostScript sont mémorisées les unes derrière les autres sous la forme d'un travail PostScript dans un ou plusieurs fichiers impression-vers-disque,
- le ou les fichier(s), impression-vers-disque, sont chargés dans le poste de montage par l'intermédiaire du réseau, le poste de montage mémorisant quelles pages sont présentes et à quelle position les différentes pages se trouvent dans le fichier impression-vers-disque correspondant,
**caractérisé en ce que**
- dans le poste de montage on établit un premier fichier de cahier PostScript qui à la place des contenus des différentes pages du ou des fichier(s) impression-vers-disque, contient des ordres d'éjection indiquant l'endroit où les différentes pages se trouvent sur le cahier d'impression, et où les différentes pages se trouvent à l'intérieur du ou des fichier(s) impression-vers-disque,
- le premier fichier cahier-PostScript ainsi établi est transmis par l'intermédiaire du réseau vers le serveur,
- dans le serveur, à l'aide des ordres d'éjection, on établit un second fichier cahier-PostScript, à l'aide des ordres d'éjection, on appelle les contenus des pages du cahier à partir du ou des fichier(s) impression-vers-disque qui se trouvent dans le serveur, et dans le premier fichier cahier-PostScript transmis par le poste de montage vers le serveur, on introduit ces contenus à l'endroit où ils se trouvent sur le cahier, et
- on transmet le second fichier cahier-PostScript du serveur vers le poste d'émission.
